# EUROPÄISCHE PATENTSCHRIFT

(11) **EP 3 033 306 B1**
(45) Veröffentlichungstag und Bekanntmachung des Hinweises auf die Patenterteilung: **28.06.2017**
(21) Anmeldenummer: 14744804.7
(22) Anmeldetag: 22.07.2014
(51) Int. Cl.: C03B 19/14, C03B 20/00, C03C 3/06

(54) **VERFAHREN ZUR HERSTELLUNG VON TITAN-DOTIERTEM KIESELGLAS FÜR DEN EINSATZ IN DER EUV-LITHOGRAPHIE**
METHOD FOR PRODUCING TITANIUM-DOPED SILICA GLASS FOR USE IN EUV LITHOGRAPHY
PROCÉDÉ DE PRODUCTION DE VERRE DE SILICE DOPÉ AU TITANE POUR UTILISATION EN LITHOGRAPHIE EUV

(30) Priorität: 16.08.2013 DE 102013108885
(43) Veröffentlichungstag der Anmeldung: 22.06.2016
(73) Patentinhaber: Heraeus Quarzglas GmbH & Co. KG, 63450 Hanau (DE)
(72) Erfinder: OCHS, Stefan, 63571 Gelnhausen (DE); BECKER, Klaus, 63452 Hanau (DE); THOMAS, Stephan, 63538 Grosskrotzenburg (DE)
(74) Vertreter: Staudt, Armin Walter
(86) Internationale Anmeldenummer: PCT/EP2014/065686
(87) Internationale Veröffentlichungsnummer: WO 2015/022152

(56) Entgegenhaltungen:
- WO-A1-2006/004169
- WO-A1-2009/106134
- DE-A1- 3 105 295
- JP-A- S5 562 822
- US-A- 3 868 170
- Anonymous: "Nitrous oxide > Air Liquide", , 22. September 2014 (2014-09-22), XP055141734, Gefunden im Internet: URL:http://www.airliquide.com/en/company/o ur-businesses-our-products/other-gases/nit rous-oxide-2.html [gefunden am 2014-09-22]

## Beschreibung

### Technischer Hintergrund

Die vorliegende Erfindung betrifft ein Verfahren zur Herstellung eines Rohlings aus Titan-dotiertem, hochkieselsäurehaltigem Glas mit einer internen Transmission von mindestens 70 % im Wellenlängenbereich von 400 nm bis 1000 nm bei einer Probendicke von 10 mm für den Einsatz in der EUV-Lithographie, umfassend die folgenden Verfahrensschritte :
(a) Herstellen eines TiO₂-SiO₂-Sootkörpers mittels Flammenhydrolyse von Silizium und Titan enthaltenden Ausgangssubstanzen,
(b) Trocknen des Sootkörpers derart, dass sich ein mittlerer Hydroxylgruppengehalt von weniger als 120 Gew.-ppm einstellt,
(c) Verglasen des Sootkörpers unter Bildung eines Rohlings aus Titan-dotiertem, hochkieselsäurehaltigem Glas.

### Stand der Technik

Bei der EUV Lithographie werden mittels mikrolithographischer Projektionsgeräte hochintegrierte Strukturen mit einer Linienbreite von weniger als 50 nm erzeugt. Dabei wird Laserstrahlung aus dem EUV-Bereich (extrem ultraviolettes Licht, auch weiche Röntgenstrahlung genannt) mit Wellenlängen um 13 nm eingesetzt. Die Projektionsgeräte sind mit Spiegelelementen ausgestattet, die aus hochkieselsäurehaltigem, mit Titandioxid dotiertem Glas (im Folgenden auch als "Ti-dotiertes Kieselglas" bezeichnet) bestehen und die mit einem reflektierenden Schichtsystem versehen sind. Diese Werkstoffe zeichnen sich durch einen extrem niedrigen thermischen Ausdehnungskoeffizienten aus, so dass sie sich durch Erwärmung während des Belichtungsprozesses nicht verformen, was zu einer Verschlechterung der Abbildungsgüte führen würde.

Das Ti-dotierte Kieselglas wird durch Flammenhydrolyse ausgehend von Silizium und Titan enthaltenden Precursorsubstanzen hergestellt. Zunächst wird ein poröser Sootkörper aus mit Titan dotiertem SiO₂ erzeugt, der nach einer Trocknung zur Reduzierung des Hydroxylgruppengehalts (OH-Gehalt) zu einem dichten Glaskörper verglast wird. Die Dotierung mit Titanoxid führt jedoch aufgrund einer mehr oder weniger starken Konzentration von Ti³⁺ Ionen in der Glasmatrix zu einer bräunlichen Färbung des Glases. Die Formkörper für diese Anwendung, im Folgenden auch Rohlinge oder Blanks genannt, sind große, dunkelbraune Platten mit Abmessungen bis zu etwa 70 x 60 x 20 cm³, die hinsichtlich ihrer optischen Eigenschaften bzw. auf herstellungsbedingte Defekte oder Inhomogenitäten überprüft werden müssen. Die bräunliche Färbung des Glases hat sich dabei als problematisch erwiesen, weil dadurch übliche optische Messverfahren, die Transparenz im sichtbaren Spektralbereich voraussetzen, nur eingeschränkt oder gar nicht anwendbar sind.

In der Literatur sind verschiedene Lösungsvorschläge gemacht worden, den Anteil der Ti³⁺ Ionen zugunsten von Ti⁴⁺ Ionen durch eine Oxidationsbehandlung zu begrenzen. Wird ein Ti-dotiertes Kieselglas mit relativ hohem Hydroxylgruppengehalt eingesetzt, ermöglichen die OH-Gruppen die gewünschte Oxidation von Ti³⁺ in Ti⁴⁺. So beschreiben es Carson u. Maurer in "Optical Attenuation In Titania-Silica Glasses", J. Non-Crystalline Solids, Vol. 11 (1973), S. 368-380, wobei eine Reaktion gemäß der Formel 2Ti³⁺ + 2OH⁻ → 2Ti⁴⁺ +2O²⁻ + H₂ angegeben wird. Bei einer entsprechenden thermischen Behandlung oxidieren die im Ti-dotierten Sootkörper enthaltenen OH-Gruppen die Ti³⁺ Ionen in Ti⁴⁺ Ionen, wobei der entstehende Wasserstoff aus dem porösen Sootkörper ausdiffundiert.

Diese Vorgehensweise wird in EP 2 428 488 A1 aufgegriffen, insbesondere hinsichtlich optimierter Bedingungen für den Prozess des Oxidierens und Ausdiffundierens des Wasserstoffs. Das in EP 2 428 488 A1 offenbarte Ti-dotierte Kieselglas hat einen hohen OH-Gehalt von mehr als 600 Gew.-ppm und einen relativ niedrigen Wasserstoffgehalt (kleiner 2 x 10¹⁷ Moleküle/cm³). Um einen hohen OH-Gehalt zu gewährleisten, wird eine Wasserdampfzugabe während des Abscheideprozesses empfohlen. Der Anteil der Ti³⁺ Ionen wird mit kleiner 3 ppm angegeben.

Aus WO 2004/089836 A1 ist ein Ti-dotiertes Kieselglas mit einer Fluor-Codotierung bekannt, das einen sehr flachen Verlauf des Wärmeausdehnugskoeffizienten über einen relativ breiten Temperaturbereich aufweist. Zunächst wird der poröse TiO₂-SiO₂-Sootkörper bei 1200°C in Luft vorgetrocknet, was eine erste Reduzierung des OH-Gehaltes und eine Oxidierung von Ti³⁺ Ionen zur Folge hat. Anschließend wird der TiO₂-SiO₂-Sootkörper zur Fluor-Dotierung bei 1000°C für mehrere Stunden einer Atmosphäre mit 10 Vol.-% SiF₄ ausgesetzt. Diese Behandlung hat neben der Fluor-Dotierung außerdem eine weitere Reduzierung des OH-Gehaltes zur Folge. Um eine Dunkelfärbung während der Verglasung des Sootkörpers zu verhindern, wird gemäß WO 2004/089836 A1 vorgeschlagen, den Sootkörper in einer Sauerstoffatmosphäre für mehrere Stunden im Temperaturbereich zwischen 300°C und 1300°C zu behandeln, bevor sich der Verglasungsschritt anschließt.

In ähnlicher Weise ist auch in WO2006/004169 A1 eine Sauerstoff-Behandlung eines TiO₂-SiO₂-Sootkörpers mit F-Codotierung vor dem Verglasen vorgesehen, um eine Dunkelfärbung durch Reduktion von TiO₂ zu verhindern. Das so hergestellte Ti-dotierte Kieselglas enthält 10 Gew.-ppm OH-Gruppen und 12 Gew.-ppm Ti³⁺ Ionen bei einem Fluorgehalt von 6300 Gew.-ppm.

Gemäß WO2009/128560 A1 wird von einem SnO₂-TiO₂-SiO₂ Glas ausgegangen, das sich ebenso wie das Ti-dotierte Kieselglas auch durch einen Wärmeausdehnungskoeffizienten von Null auszeichnet. Zinn, ebenso wie weitere in WO2009/128560 A1 genannte Elemente, wirkt als ein sogenannter Ti³⁺ Inhibitor. Voraussetzung ist allerdings, dass das Zinn zumindest überwiegend als Sn⁴⁺ Ion bzw. als SnO₂ vorliegt. Ist nämlich eine relevante Menge Sn²⁺ vorhanden, stellt sich die gewünschte Wirkung hinsichtlich einer Verringerung der Konzentration von Ti³⁺ Ionen nicht ein, vielmehr trägt Sn²⁺ noch zusätzlich zur Absorption im sichtbaren Wellenlängenbereich bei. Andererseits besteht bei einem zu hohen Anteil von Sn⁴⁺ Ionen die Gefahr von kristallinen SnO₂-Ausscheidungen. Insgesamt muss daher das SnO₂-TiO₂-SiO₂ Glas in seiner Zusammensetzung sehr genau eingestellt werden, was seine Herstellung aufwendig gestaltet. In WO2009/128560 A1wird deshalb auch für dieses Glas eine Sauerstoffbehandlung des entsprechenden Sootkörpers vor dem Verglasen vorgeschlagen.

Aus WO 2009/106134 A1 schließlich ist eine thermisch-oxidative Behandlung eines getrockneten SiO₂-Sootkörpers, ohne Titan-Dotierung, bekannt. Der SiO₂-Sootkörper wird mit einem Stickstoff enthaltenden Gas (Stickoxide, Ammoniak) behandelt, damit die Sauerstoff-Defektzentren im Gasnetzwerk unter Bildung von Si-N Verbindungen reagieren. Es resultiert somit ein mit Stickstoff dotiertes Quarzglas.

### Technische Aufgabenstellung

Zusammenfassend ist festzustellen, dass nach dem Stand der Technik die Reduzierung von Ti³⁺ Ionen zugunsten von Ti⁴⁺ Ionen in Ti-dotiertem Kieselglas entweder durch einen ausreichen hohen Anteil an OH-Gruppen sicher gestellt wird, wodurch eine interne Oxidation mit Ausdiffusion von Wasserstoff erfolgt, oder bei niedrigem OH-Gruppenanteil eine Sauerstoffbehandlung vor dem Verglasen erforderlich ist, die eine hohe Behandlungstemperatur und spezielle korrosionsbeständige Öfen erfordert und dementsprechend kostspielig ist.

Der Erfindung liegt die Aufgabe zugrunde, ein kostengünstiges Herstellungsverfahren für mit Titan dotiertem hochkieselsäurehaltigen Glas anzugeben, das bei einem Hydroxylgruppengehalt von weniger als 120 ppm eine interne Transmission bei einer Probendicke von 10 mm von mindestens 70% im Wellenlängenbereich von 400 nm bis 1000 nm zeigt.

### Allgemeine Beschreibung der Erfindung

Hinsichtlich des Verfahrens wird diese Aufgabe ausgehend von dem Verfahren der eingangs genannten Gattung erfindungsgemäß dadurch gelöst, dass der TiO₂-SiO₂-Sootkörper vor dem Verglasen gemäß Verfahrensschritt (c) einer Konditionierungsbehandlung unterzogen wird, die eine Behandlung mit einem Stickoxid umfasst, und dass zum Austreiben von Reaktionsgasen aus dem Sootkörper nach der Konditionierungsbehandlung mit dem Stickoxid und vor dem Verglasen gemäß Verfahrensschritt (c) eine thermische Behandlung in einem Temperaturbereich von 600 °C bis 1000 °C durchgeführt wird.

Bei der Herstellung von synthetischem, Ti-dotiertem Kieselglas nach dem so genannten "Sootverfahren" durch Flammenhydrolyse werden in der Flamme durch Hydrolyse oder Oxidation erzeugte SiO₂- und TiO₂-Partikel zunächst unter Bildung eines TiO₂-SiO₂-Sootkörpers auf einer Ablagerungsfläche abgeschieden. Erst in Sootkörpers in einer Sauerstoffatmosphäre, wie dies aus dem Stand der Technik bekannt ist. Mit dem erfindungsgemäßen Verfahren ist es daher möglich die Konditionierungsbehandlung in einem Grafitofen durchzuführen, der auch für das Trocknen und das Verglasen des Sootkörpers unter Vakuum oder/und unter Edelgas eingesetzt wird. Das Umsetzen des Sootkörpers in einen Sauerstoffbeständigen Ofen, wie dies nach dem Stand der Technik nötig ist, ist nicht erforderlich. Das erfindungsgemäße Verfahren ist damit besonders wirtschaftlich.

Der Hydroxylgruppengehalt (OH-Gehalt) ergibt sich durch Messung der IR-Absorption nach der Methode von D. M. Dodd et al. ("Optical Determinations of OH in Fused Silica", (1966), S. 3911).

Um ein vollständiges Austreiben des bei der Oxidation von Ti³⁺ zu Ti⁴⁺ entstehenden, molekularen, gasförmigen Stickstoffs und etwaiger anderer Reaktionsgase aus dem Sootkörper zu gewährleisten, wird nach der Konditionierungsbehandlung mit dem Stickoxid und vor dem Verglasen gemäß Verfahrensschritt (c) eine thermische Behandlung in einem Temperaturbereich von 600 °C bis 1000 °C durchgeführt.

Dabei wird kein Stickoxid mehr zugeführt, vielmehr ist vorteilhaft, einen Unterdruck von etwa 10⁻¹ mbar oder darunter anzulegen. Wird diese thermische Nachbehandlung unterlassen und nach der Konditionierungsbehandlung sogleich mit hoher Aufheizgeschwindigkeit auf die Verglasungstemperatur aufgeheizt, besteht die Gefahr der Blasenbildung aufgrund von nicht ausdiffundiertem Stickstoff.

Nachfolgend werden geeignete Verfahrensmodifikationen für die Behandlung mit Stickoxiden näher erläutert.

Es hat sich gezeigt, dass besonders vorteilhaft Distickstoffmonoxid (N₂O), auch als "Lachgas" bezeichnet, als Stickoxid für die Konditionierungsbehandlung eingesetzt wird. Distickstoffmonoxid hat den besonderen Vorteil, dass es großtechnisch in hoher Reinheit erhältlich und relativ ungiftig und ungefährlich ist. Bei der thermischen Zersetzung von Distickstoffmonoxid entstehen besonders reaktive Stickstoff- und Sauerstoffatome, die bereits bei Raumtemperatur mit den Ti³⁺ Ionen reagieren. Die niedrige Behandlungstemperatur ermöglicht den Einsatz konstruktiv Sootkörpers in einer Sauerstoffatmosphäre, wie dies aus dem Stand der Technik bekannt ist. Mit dem erfindungsgemäßen Verfahren ist es daher möglich die Konditionierungsbehandlung in einem Grafitofen durchzuführen, der auch für das Trocknen und das Verglasen des Sootkörpers unter Vakuum oder/und unter Edelgas eingesetzt wird. Das Umsetzen des Sootkörpers in einen Sauerstoffbeständigen Ofen, wie dies nach dem Stand der Technik nötig ist, ist nicht erforderlich. Das erfindungsgemäße Verfahren ist damit besonders wirtschaftlich.

Der Hydroxylgruppengehalt (OH-Gehalt) ergibt sich durch Messung der IR-Absorption nach der Methode von D. M. Dodd et al. ("Optical Determinations of OH in Fused Silica", (1966), S. 3911).

Nachfolgend werden geeignete Verfahrensmodifikationen für die Behandlung mit Stickoxiden näher erläutert.

Es hat sich gezeigt, dass besonders vorteilhaft Distickstoffmonoxid (N₂O), auch als "Lachgas" bezeichnet, als Stickoxid für die Konditionierungsbehandlung eingesetzt wird. Distickstoffmonoxid hat den besonderen Vorteil, dass es großtechnisch in hoher Reinheit erhältlich und relativ ungiftig und ungefährlich ist. Bei der thermischen Zersetzung von Distickstoffmonoxid entstehen besonders reaktive Stickstoff- und Sauerstoffatome, die bereits bei Raumtemperatur mit den Ti³⁺ Ionen reagieren. Die niedrige Behandlungstemperatur ermöglicht den Einsatz konstruktiv vergleichsweise einfacher Öfen, die beispielsweise auch Ofenteile aus Grafit enthalten können.

Alternativ zu Distickstoffmonoxid kann auch Stickstoffdioxid (NO₂) eingesetzt werden, das ebenfalls bei der thermischen Zersetzung besonders reaktive Stickstoff- und Sauerstoffatome freisetzt.

Die Reaktion der Ti³⁺ Ionen mit Distickstoffmonoxid bzw. Stickstoffdioxid erfolgt nach den folgenden Reaktionsgleichungen (1) und (2) unter Freisetzung von Stickstoff (N₂) :

(1) 2 Ti³⁺ + N₂O → 2 Ti⁴⁺ + O²⁻ + N₂

(2) 8 Ti³⁺ + 2 NO₂ → 8 Ti⁴⁺ + 4 O²⁻ + N₂

Es hat sich bewährt, die Konditionierungsbehandlung mit dem Stickoxid bei einer Behandlungstemperatur im Bereich von 20 °C bis 600 °C, vorzugsweise im Bevergleichsweise einfacher Öfen, die beispielsweise auch Ofenteile aus Grafit enthalten können.

Alternativ zu Distickstoffmonoxid kann auch Stickstoffdioxid (NO₂) eingesetzt werden, das ebenfalls bei der thermischen Zersetzung besonders reaktive Stickstoff- und Sauerstoffatome freisetzt.

Die Reaktion der Ti³⁺ Ionen mit Distickstoffmonoxid bzw. Stickstoffdioxid erfolgt nach den folgenden Reaktionsgleichungen (1) und (2) unter Freisetzung von Stickstoff (N₂) :

(1) 2 Ti³⁺ + N₂O → 2 Ti⁴⁺ + O²⁻ + N₂

(2) 8 Ti³⁺ + 2 NO₂ → 8 Ti⁴⁺ + 4 O²⁻ + N₂

Es hat sich bewährt, die Konditionierungsbehandlung mit dem Stickoxid bei einer Behandlungstemperatur im Bereich von 20 °C bis 600 °C, vorzugsweise im Bereich 20 °C bis 500 °C, und für eine Dauer von mindestens einer Stunde durchzuführen.

Da die Konditionierungsbehandlung bereits bei Raumtemperatur (20 °C bis etwa 25 °C) ohne den Einsatz einer Heizung erfolgen kann, ist eine Oxidation der Ti³⁺ Ionen mit vergleichsweise geringem Energieaufwand möglich. Wenn überhaupt, so ist nur der Einsatz konstruktiv wenig aufwendiger Öfen erforderlich. Es ist daher auch möglich die thermische Konditionierungsbehandlung unter Stickoxid enthaltender Atmosphäre durch mehrmaliges Durchlaufen dieser Behandlungsphase zu wiederholen. Bei Temperaturen unterhalb von etwa 600 °C bleibt die poröse Struktur des Sootkörpers erhalten, so dass sichergestellt ist, dass die gasförmigen Behandlungsreagenzien den Sootkörper durch Diffusion durchdringen und gleichmäßig mit den im Glasnetzwerk verteilten Ti³⁺ Ionen reagieren können. Bei Raumtemperatur erfolgt eine sogenannte "Kaltinfiltration" mit dem Stickoxid enthaltenden Gas, so dass bei entsprechend langer Dauer der Behandlung auch die gewünschte oxidative Reaktion mit den Ti³⁺ Ionen eintritt. Eine schnellere Reaktion bei der Behandlung mit Stickoxid kann erzielt werden, wenn im Bereich der spezifischen Zersetzungstemperatur des eingesetzten Stickoxids gearbeitet wird. In der Regel laufen die Zersetzungsreaktionen ab einer Temperatur von etwa150 °C ab. Je nach Behandlungstemperatur richtet sich die Behandlungsdauer auch nach dem Volumen des Sootkörpers. Eine Mindestbehandlungsdauer von mindestens einer Stunden hat sich bewährt, um eine effektive Infiltration des Sootkörpers mit dem Stickoxid zu gewährleisten. Es wird dabei eine im Wesentlichen gleichmäßige Verteilung des Behandlungsgases innerhalb des porösen Sootkörpers erreicht. Das Stickoxid wird dabei vorzugsweise mittels eines inerten Trägergasstroms in den Sootkörper eingebracht.

Vorteilhafterweise beträgt der Anteil des stickoxidhaltigen Gases in Inertgas während der Konditionierungsbehandlung zwischen 0,1 und 20 Vol.-%, vorzugsweise zwischen 5 und 10 Vol.-%.

Bei Stickoxidgehalten unterhalb von 0,1 Vol.-% ergibt sich eine geringe oxidative Wirkung und bei Stickoxidanteilen oberhalb von 20 Vol.-% kann es zu einer Überbeladung mit Stickstoff und einer daraus resultierenden Blasenbildung beim nachfolgenden Behandeln bei hoher Temperatur kommen, wie beispielsweise beim Verglasen.

Eine weitere vorteilhafte Ausgestaltung der Erfindung besteht darin, eine Dotier-Behandlung des TiO₂-SiO₂-Sootkörpers in einer Fluor enthaltenden Atmosphäre durchzuführen, die vorzugsweise vor der Konditionierungsbehandlung mit einem Stickoxid stattfindet.

Hierdurch wird eine Fluor-Dotierung des TiO₂-SiO₂-Sootkörpers erreicht. Fluor hat Einfluss auf die Strukturrelaxation von Kieselglas, so dass für das Ti-dotierte Kieselglas die fiktive Temperatur als Maß für den Ordnungszustand des "eingefrorenen" Glasnetzwerkes gesenkt und der Temperaturbereich mit einem Wärmeausdehnungskoeffizienten von Null erweitert werden kann. Dies ist beispielsweise aus Journal of Applied Physics, Vol. 91 (8), April 2002, S.4886-4890 bekannt. Die Dotier-Behandlung wird zwar bevorzugt vor der Konditionierungsbehandlung durchgeführt, eine umgekehrte Abfolge ist aber auch möglich, soweit die Dotier-Behandlung die durch die Konditionierungsbehandlung erreichte minimierte Ti³⁺ Konzentration nicht wieder erhöht. Je nach Behandlungsdauer und Temperatur wird eine Fluorkonzentration zwischen 1000 Gew.-ppm und 10 000 Gew.-ppm, vorzugsweise zwischen 6500 Gew.-ppm und 10 000 Gew.-ppm, eingestellt.

Eine besonders wirtschaftliche Verfahrensweise wird erreicht, wenn das Trocknen gemäß Verfahrensschritt (b) ganz oder teilweise bei der Dotier-Behandlung erfolgt.

Somit kann die Dehydratation des Sootkörpers und die Fluor-Dotierung gleichzeitig durchgeführt werden, was das gesamte Herstellungsverfahren zeitlich verkürzt, ohne an Effizienz zu verlieren.

Vorteilhaft ist es zudem, wenn die Dotier-Behandlung in einer Fluor enthaltenden Atmosphäre in einem Temperaturbereich von 20 °C bis maximal 1000 °C durchgeführt wird. Bei einer Dotier-Behandlung in diesem Temperaturbereich ist der poröse Sootkörper gut durchlässig für das Fluor enthaltende Behandlungsgas. Außerdem ist nur eine geringe Wärmezufuhr, - wenn überhaupt - nötig, um einen Einbau von Fluor in das Glasnetzwerk zu gewährleisten.

Er hat sich bewährt, wenn als Fluor enthaltende Atmosphäre eine InertgasAtmosphäre mit 10 bis 100 Vol.-% SiF₄ eingesetzt wird. Grundsätzlich kann an Stelle von SiF₄ auch reines Fluor-Gas (F₂) oder SiHF₃ oder SiH₂F₂ eingesetzt werden.

Der Einsatz von Kohlenstoff enthaltenden fluorierenden Gasen wie etwa CHF₃, CF₄, C₂F₆ oder C₃F₈ sind aufgrund ihrer reduzierenden Wirkung eher ungünstig, da dies die Bildung unerwünschter Ti³⁺ Ionen unterstützen würde.

Der nach dem erfindungsgemäßen Verfahren hergestellte Rohling zeigt aufgrund seines geringen Anteils an Ti³⁺ Ionen hohe Transparenz im Wellenlängenbereich von 400 nm bis 1000 nm. Dadurch ist die Inspektion des Rohlings mit üblichen optischen Messverfahren ohne weiteres möglich. Die Dotierung mit TiO₂ liegt im Bereich von 6 Gew.-% bis 12 Gew.-%, der OH-Gehalt liegt bei weniger als 120 Gew.-ppm.

Die Bestimmung der Konzentration von Ti³⁺ kann durch eine Elektronen-Spin- Resonanz-Messung erfolgen, wie sie beispielsweise in der Veröffentlichung von Carson und Maurer in "Optical Attenuation In Titania-Silica Glasses", J. Non-Crystalline Solids, Vol. 11 (1973), S. 368-380 erwähnt wird.

Vorteilhafterweise weist der nach dem erfindungsgemäßen Verfahren hergestellte Rohling aus Ti-dotiertem Kieselglas eine Dotierung mit Fluor auf. Im Sinne eines besonders flachen Verlaufs des Wärmeausdehnungskoeffizienten von Null über einen Temperaturbereich von 20 °C bis 50 °C liegt die Fluordotierung im Bereich von 1000 Gew.-ppm bis 10 000 Gew.-ppm, vorzugsweise im Bereich von 6500 Gew.-ppm bis 10 000 Gew.-ppm.

Die mittlere Fluor-Konzentration wird üblicherweise nasschemisch ermittelt. Dabei wird eine Messprobe des Rohlings zunächst in wässriger NaOH-Lösung aufgelöst. Die F-Konzentration ergibt sich durch Messung der elektromotorischen Kraft der gelösten Messprobe mittels einer Fluor sensitiven Elektrode.

Der nach dem erfindungsgemäßen Verfahren hergestellte Rohling ist für den Einsatz in der EUV-Lithographie bestens geeignet. Dies nicht zuletzt da aufgrund seiner Transparenz im sichtbaren Spektralbereich eine optimale Inspektion vor weiteren Verarbeitungsschritten beispielsweise zu einem Spiegelsubstrat möglich ist.

### Referenzbeispiele

Nachfolgend wird die Erfindung anhand der Referenzbeispiele 1-4 näher erläutert.

### Beispiel 1

Es wird ein Sootkörper durch Flammenhydrolyse von Octamethylcyclotetrasiloxan (OMCTS) und Titan-Isopropoxid [Ti(OPrⁱ)₄] anhand des bekannten "Outside-Vapor-Deposition-Verfahrens" (OVD-Verfahren) hergestellt. Der Sootkörper besteht aus synthetischem Kieselglas, das mit 8 Gew.-% TiO₂ dotiert ist.

Der Sootkörper wird bei einer Temperatur von 1100 °C in einem Heizofen mit einem Heizelement aus Grafit unter Vakuum getrocknet. Das im Heizofen vorhandene Grafit bewirkt die Einstellung reduzierender Bedingungen, was den Anteil an Ti³⁺ Ionen im Sootkörper erhöht. Bei Abschluss der Dehydratationsbehandlung nach 50 Stunden liegt der Hydroxylgruppengehalt des Sootkörpers bei etwa 15 Gew.-ppm.

Der thermisch getrocknete TiO₂-SiO₂-Sootkörper wird anschließend bei einer Temperatur im Bereich von 450 °C bis 600 °C in einer N₂O enthaltenden Atmosphäre (Lachgas-Atmosphäre) behandelt. Dabei wird der Sootkörper zunächst mit dem Distickstoffmonoxid oder Lachgas in einem Trägergasstrom aus Stickstoff bei Temperaturen von 450 °C während 50 Stunden thermisch behandelt und unter Aufrechterhaltung des N₂O/N₂-Gasstromes die Temperatur von 450 °C auf 600 °C erhöht. Die Lachgaskonzentration wird während dieser Vorbehandlungsphase auf 5 Vol.-% eingestellt.

Danach wird der getrocknete und nachbehandelte TiO₂-SiO₂-Sootkörper in einem Sinterofen bei einer Temperatur von ca. 1400 °C unter Helium oder unter Vakuum (bei etwa 10⁻² mbar) zu einem transparenten Ti-dotierten Kieselglasrohling verglast. Dieser wird anschließend durch thermisch mechanische Homogenisierung (Verdrillen) und Bildung eines Ti-dotierten Kieselglas-Rohlings homogenisiert.

Es folgt ein weiterer Umformprozess zu einem zylindrischen Formkörper. Dabei wird der Rohling in eine Schmelzform aus Grafit gestellt, die einen Boden mit rundem Querschnitt und einem Außendurchmesser von 300 mm aufweist. Zum Verformen wird die gesamte Schmelzform mit dem darin befindlichen Rohling zunächst auf 1250 °C und anschließend mit einer Rampe 9 °C/min auf 1600 °C aufgeheizt und danach mit einer Rampe von 2 °C/min auf eine Temperatur von 1680 °C. Bei dieser Temperatur wird die Kieselglasmasse so lange gehalten, bis das erweichte Ti-dotierte Kieselglas unter Wirkung seines eigenen Gewichts in den Boden der Schmelzform ausgeflossen ist und diese dabei aufgefüllt hat. Aus dem Rohling wird so eine runde Platte mit einem Durchmesser von 300 mm und einer Dicke von etwa 60 mm geformt, die in allen drei Betrachtungsrichtungen schichten- und schlierenfrei ist.

Zum Abbau mechanischer Spannungen und zur Verminderung der Doppelbrechung wird der Ti-dotierte Kieselglas-Rohling einer Temperbehandlung unterzogen, bei der der zylindrische Rohling während einer Haltezeit von 8 Stunden unter Luft und Atmosphärendruck auf 1100 °C erhitzt und anschließend mit einer Abkühlrate von 4 °C/h auf eine Temperatur von 950 °C abgekühlt und bei dieser Temperatur 4 Stunden lang gehalten wird. Danach folgt eine Abkühlung auf 300°C mit einer höheren Abkühlrate von 50 °C/h, woraufhin der Ofen abgestellt und der Rohling der freien Abkühlung des Ofens überlassen wird.

Da der Rohling in seinen Randbereichen eine relativ starke Spannungsdoppelbrechung aufweist, wird von den Stirnflächen ein Teil des Übermaßes gegenüber der Bauteil-Kontur abgenommen, nämlich eine Dicke von 3 mm. Der Rohling zeichnet sich aufgrund eines Verhältnisses Ti³⁺/Ti⁴⁺ von 6 x 10⁻⁵ durch hohe Transparenz im sichtbaren Spektralbereich aus und kann nun mit den üblichen optischen Messverfahren inspiziert und entsprechend den resultierenden Messergebnissen weiteren Verarbeitungsschritten zugeführt werden. Die interne Transmission beträgt 80 % gemessen an einer Probe mit einer Dicke von 10 mm. Unter interner Transmission wird die Transmission über die Probendicke korrigiert um den Anteil der Oberflächenverluste bezeichnet.

### Beispiel 2

Ein anderer Rohling aus Ti-dotiertem Kieselglas wird wie oben anhand Beispiel 1 beschrieben hergestellt, mit dem Unterschied, dass als Oxidationsmittel anstelle von Distickstoffmonoxid (N₂O, Lachgas) Stickstoffdioxid (NO₂) eingesetzt wird.

Hierzu wird der TiO₂-SiO₂-Sootkörper nach dem Trocknen in einer Stickstoffdioxidatmosphäre behandelt. NO₂ bildet sich in situ aus einer Mischung aus NO und O₂, wobei diese Gase in einem Trägergasstrom aus Stickstoff in einen Behandlungsofen bei einer Temperatur von 150 °C eingebracht werden und dort auf den Sootkörper einwirken. Nach einer Behandlungsdauer von vier Stunden wird die Temperatur auf 400 °C erhöht, und bei dieser Temperatur wird die Probe 40 Stunden lang behandelt, so dass sich die Stickstoffdioxidkonzentration auf 5 Vol.-% einstellt.

Oberhalb von 200 °C zerfällt NO₂ in Sauerstoff und reaktive Stickstoffatome oder - verbindungen, die in der Lage sind Ti³⁺ in der Glasnetzwerkstruktur zu Ti⁴⁺ Ionen zu oxidieren.

Der getrocknete und behandelte TiO₂-SiO₂-Sootkörper wird gesintert und homogenisiert, wie anhand Beispiel 1 beschrieben. Der danach erhaltene Rohling ist im Wesentlichen frei von Ti³⁺ Ionen; der Hydroxylgruppengehalt beträgt 15 Gew.-ppm.

### Beispiel 3

Bei einer Modifikation des Herstellungsverfahrens wie anhand Beispiel 1 beschrieben, wird der TiO₂-SiO₂-Sootkörper nach dem Trocknungsschritt einer Dotier-Behandlung in einer 20 Vol.-% SiF₄ enthaltenden Atmosphäre unterzogen.

Diese Behandlung erfolgt bei einer Temperatur von 900 °C und während einer Dauer von 10 h. Dies führt zu einem festen Einbau von Fluor in den zu verglasenden TiO₂-SiO₂-Sootkörper. Für die nachfolgende Oxidationsbehandlung unter Stickoxidhaltiger Atmosphäre (5 Vol.-% N₂O) bei einer Temperatur von 400 °C wurde eine Behandlungsdauer von 35 Stunden angewendet.

Der Sootkörper wird danach verglast und weiterbehandelt, wie anhand von Beispiel 1 beschrieben. Der so erhaltene Ti-dotierte Kieselglaszylinder ist im Wesentlichen frei von Ti³⁺ Ionen, und er zeichnet sich durch einen mittleren Fluorgehalt von 8940 Gew.-ppm sowie durch einen Hydroxylgruppengehalt unterhalb der Nachweisgrenze (< 1 Gew.-ppm) aus.

### Beispiel 4

Beispiel 4 betrifft eine Variante von Beispiel 3 mit Fluor Co-Dotierung des TiO₂-SiO₂-Sootkörpers in Kombination mit dem Trocknungsschritt. Hierbei wird der TiO₂-SiO₂-Sootkörper also nicht erst einer thermischen Trocknung unterzogen, sondern der Sootkörper wird nach dem Abscheiden direkt mit einer Fluor enthaltenden Atmosphäre aus N₂/SiF₄ bei 1000°C behandelt. Der Volumenanteil von SiF₄ im Inertgas (N₂) beträgt 10 Vol.-%. Die Behandlung wird für 10 Stunden durchgeführt. Anschließend folgt eine Behandlung mit Lachgas (N₂O) und danach die Verglasung und Homogenisierung wie in Beispiel 1 beschrieben.

Der so erhaltene Ti-dotierte Kieselglaszylinder ist im Wesentlichen frei von Ti³⁺ Ionen, und er zeichnet sich durch einen mittleren Fluorgehalt von 6700 Gew.-ppm sowie durch einen Hydroxylgruppengehalt unterhalb der Nachweisgrenze (< 1 Gew.-ppm) aus.

## Patentansprüche

1. Verfahren zur Herstellung eines Rohlings aus Titan-dotiertem, hochkieselsäurehaltigem Glas mit einer internen Transmission von mindestens 70 % im Wellenlängenbereich von 400 nm bis 1000 nm bei einer Probendicke von 10 mm für den Einsatz in der EUV-Lithographie, umfassend die folgenden Verfahrensschritte :
(a) Herstellen eines TiO₂-SiO₂-Sootkörpers mittels Flammenhydrolyse von Silizium und Titan enthaltenden Ausgangssubstanzen
(b) Trocknen des Sootkörpers derart, dass sich ein mittlerer Hydroxylgruppengehalt von weniger als 120 Gew.-ppm einstellt,
(c) Verglasen des Sootkörpers unter Bildung eines Rohlings aus Titan-dotiertem, hochkieselsäurehaltigem Glas,
**dadurch gekennzeichnet, dass** der TiO₂-SiO₂-Sootkörper vor dem Verglasen gemäß Verfahrensschritt (c) einer Konditionierungsbehandlung unterzogen wird, die eine Behandlung mit einem Stickoxid umfasst, und dass zum Austreiben von Reaktionsgasen aus dem Sootkörper nach der Konditionierungsbehandlung mit dem Stickoxid und vor dem Verglasen gemäß Verfahrensschritt (c) eine thermische Behandlung in einem Temperaturbereich von 600 °C bis 1000 °C durchgeführt wird..

2. Verfahren nach Anspruch 1, **dadurch gekennzeichnet, dass** die Konditionierungsbehandlung mit Distickstoffmonoxid (N₂O) als Stickoxid durchgeführt wird.

3. Verfahren nach Anspruch1, **dadurch gekennzeichnet, dass** die Konditionierungsbehandlung mit Stickstoffdioxid (NO₂) als Stickoxid durchgeführt wird.

4. Verfahren nach einem der vorhergehenden Ansprüche, **dadurch gekennzeichnet, dass** die Konditionierungsbehandlung mit dem Stickoxid bei einer Behandlungstemperatur im Bereich von 20°C bis 600 °C, vorzugsweise im Bereich 20°C bis 500 °C, und für eine Dauer von mindestens einer Stunde durchgeführt wird.

5. Verfahren nach einem der vorhergehenden Ansprüche, **dadurch gekennzeichnet, dass** bei der Konditionierungsbehandlung mit dem Stickoxid der Anteil des stickoxidhaltigen Gases in Inertgas zwischen 0,1 und 20 Vol.-%vorzugsweise zwischen 5 und 10 Vol.-% beträgt.

6. Verfahren nach einem der vorhergehenden Ansprüche, **dadurch gekennzeichnet, dass** eine Dotier-Behandlung des TiO₂-SiO₂-Sootkörpers in einer Fluor enthaltenden Atmosphäre, vorzugsweise vor der Konditionierungsbehandlung mit dem Stickoxid durchgeführt wird.

7. Verfahren nach Anspruch 6, **dadurch gekennzeichnet, dass** das Trocknen gemäß Verfahrensschritt (b) ganz oder teilweise bei der Dotier-Behandlung erfolgt.

8. Verfahren nach Anspruch 6 oder 7, **dadurch gekennzeichnet, dass** die Dotier-Behandlung in einem Temperaturbereich von 20 °C bis maximal 1000 °C durchgeführt wird

9. Verfahren nach einem der Ansprüche 6 bis 8, **dadurch gekennzeichnet, dass** die Fluor enthaltende Atmosphäre bei der Dotier-Behandlung eine InertgasAtmosphäre mit 10 Vol.-% bis 100 Vol.-% SiF₄ enthält.

## Claims

1. A method for producing a blank of titanium-doped glass having a high silicic-acid content with an internal transmission of at least 70% in the wavelength range of 400 nm to 1000 nm at a sample thickness of 10 mm for use in EUV lithography, comprising the following method steps:
(a) producing a TiO₂-SiO₂ soot body by means of flame hydrolysis of silicon- and titanium-containing precursor substances,
(b) drying the soot body such that a mean hydroxyl group content of less than 120 wt. ppm is obtained,
(c) vitrifying the soot body to form a blank of titanium-doped glass having a high silicic-acid content.
**characterized in that** prior to vitrifying according to method step (c) the TiO₂-SiO₂ soot body is subjected to a conditioning treatment which comprises a treatment with a nitrogen oxide, and that for expulsion of reaction gases out of the soot body after the conditioning treatment with the nitrogen oxide and prior to vitrifying according to method step (c) a thermal treatment is carried out in a temperature range of 600°C to 1000°C.

2. The method according to claim 1, **characterized in that** the conditioning treatment is carried out with nitrous oxide (N₂O) as the nitrogen oxide.

3. The method according to claim 1, **characterized in that** the conditioning treatment is carried out with nitrogen dioxide (NO₂) as the nitrogen oxide.

4. The method according to any one of the preceding claims, **characterized in that** the conditioning treatment is carried out with the nitrogen oxide at a treatment temperature in the range of 20°C to 600°C, preferably in the range of 20°C to 500°C, and for a period of at least one hour.

5. The method according to any one of the preceding claims, **characterized in that** in the conditioning treatment with the nitrogen oxide the amount of the nitrogen oxide-containing gas in inert gas is between 0.1 and 20% by vol., preferably between 5 and 10% by vol.

6. The method according to any one of the preceding claims, **characterized in that** a doping treatment of the TiO₂-SiO₂ soot body is carried out in a fluorine-containing atmosphere, preferably before the conditioning treatment with the nitrogen oxide.

7. The method according to claim 6, **characterized in that** drying according to method step (b) is carried out fully or in part during the doping treatment.

8. The method according to claim 6 or 7, **characterized in that** the doping treatment is carried out in a temperature range of 20°C to not more than 1000°C.

9. The method according to any one of claims 6 to 8, **characterized in that** the fluorine-containing atmosphere during the doping treatment contains an inert gas atmosphere with 10% by vol. to 100% by vol. of SiF₄.

## Revendications

1. Procédé de fabrication d'une ébauche en verre dopé au titane, à haute teneur en acide silicique, par une transmission interne d'au moins 70% dans la plage de longueur d'onde de 400 nm à 1000 nm avec une épaisseur d'échantillon de 10 nm pour l'utilisation en lithographie EUV, comprenant les étapes de procédé suivantes :
(a) fabrication d'un corps de suie TiO₂-SiO₂ par hydrolyse à la flamme de substances de départ contenant de la silice et du titane
(b) séchage du corps de suie de manière à ce qu'une teneur en groupes hydroxyles moyenne de moins de 120 ppm en poids se règle,
(c) vitrification du corps de suie avec formation d'une ébauche en verre dopé au titane, à haute teneur en acide silicique,
**caractérisé en ce que** le corps de suie TiO₂-SiO₂, avant la vitrification selon l'étape de procédé (c), est exposé à un traitement de conditionnement qui comprend un traitement avec un oxyde d'azote, et **en ce que** pour l'expulsion de gaz réactionnels hors du corps de suie après le traitement de conditionnement avec l'oxyde d'azote et avant la vitrification selon l'étape de procédé (c), un traitement thermique est réalisé dans une plage de température de 600°C à 1000°C.

2. Procédé selon la revendication 1, **caractérisé en ce que** le traitement de conditionnement est réalisé avec de l'oxyde nitreux (N₂O) en tant qu'oxyde d'azote.

3. Procédé selon la revendication 1, **caractérisé en ce que** le traitement de conditionnement est réalisé avec du dioxyde d'azote (N₂O) en tant qu'oxyde d'azote.

4. Procédé selon l'une quelconque des revendications précédentes, **caractérisé en ce que** le traitement de conditionnement avec l'oxyde d'azote est réalisé à une température de traitement située dans la plage de 20°C à 600°C, de préférence dans la plage de 20°C à 500°C, et pour une durée d'au moins une heure.

5. Procédé selon l'une quelconque des revendications précédentes, **caractérisé en ce que** lors du traitement de conditionnement avec l'oxyde d'azote, la proportion du gaz contenant de l'oxyde d'azote en gaz inerte est comprise entre 0,1 et 20% en volume, de préférence entre 5 et 10% en volume.

6. Procédé selon l'une quelconque des revendications précédentes, **caractérisé en ce qu'**un traitement de dopage du corps de suie TiO₂-SiO₂ est réalisé dans une atmosphère contenant du fluor, de préférence avant le traitement de conditionnement avec l'oxyde d'azote.

7. Procédé selon la revendication 6, **caractérisé en ce que** le séchage selon l'étape de procédé (b) est réalisé entièrement ou en partie lors du traitement de dopage.

8. Procédé selon la revendication 6 ou 7, **caractérisé en ce que** le traitement de dopage est réalisé dans une plage de température de 20°C à maximum 1000°C.

9. Procédé selon l'une quelconque des revendications 6 à 8, **caractérisé en ce que** l'atmosphère contenant du fluor, lors du traitement de dopage, contient une atmosphère de gaz inerte comprenant 10% en volume à 100% en volume de SiF₄.
